(19) Europäisches Patentamt
European Patent Office
Office européen des brevets

(11) EP 0 398 683 B1

(12) **EUROPEAN PATENT SPECIFICATION**

(45) Date of publication and mention
of the grant of the patent:
**07.01.1998 Bulletin 1998/02**

(51) Int Cl.⁶: **G02F 1/136**, H01L 27/12

(21) Application number: **90305280.1**

(22) Date of filing: **16.05.1990**

(54) **Liquid crystal display unit**

Flüssigkristallanzeigeeinheit

Unité d'affichage à cristal liquide

(84) Designated Contracting States:
**DE FR GB**

(30) Priority: **18.05.1989 JP 124718/89**

(43) Date of publication of application:
**22.11.1990 Bulletin 1990/47**

(60) Divisional application: **97101964.1**

(73) Proprietor: **SEIKO EPSON CORPORATION**
**Shinjuku-ku Tokyo (JP)**

(72) Inventor: **Takahashi, Kotoyoshi,**
**c/o SEIKO EPSON CORPORATION**
**Suwa-shi, Nagano-ken (JP)**

(74) Representative: **Sturt, Clifford Mark et al**
**J. MILLER & CO.**
**34 Bedford Row,**
**Holborn**
**London WC1R 4JH (GB)**

(56) References cited:
**GB-A- 2 050 031**

- **PATENT ABSTRACTS OF JAPAN, vol. 12, no. 156 (P-701[3003], 13th May 1988; & JP- A-62 272 228 (MATSUSHITA ELECTRIC) 26-11-1987**
- **PATENT ABSTRACTS OF JAPAN, vol. 13, no. 361 (P-917)[3709], 11th August 1989; & JP-A-01 120 539 (SEIKO EPSON) 12-05-1989**
- **PATENT ABSTRACTS OF JAPAN, vol. 11, no. 299 (P-621)[2746], 29th September 1987;**
- **& JP-A-62 092 919 (SHARP CORP.) 28-04-1987**

## Description

The present invention relates to a liquid crystal display unit having a liquid crystal layer between a pair of substrates, pixel electrodes and elements for driving the pixel electrodes arranged in a matrix on one of the pair of substrates, and inter-pixel connections for applying signals to the driving elements.

Conventionally, the elements for driving the pixels of a display unit are non-linear elements with two terminals, typically being non-linear elements employing inorganic film and comprising a metal-insulator-metal (MIM), metal-semi-insulator (MSI), ring diode, back to back diode, varistor and the like structure, or non-linear elements employing organic film such as polyimide and the like.

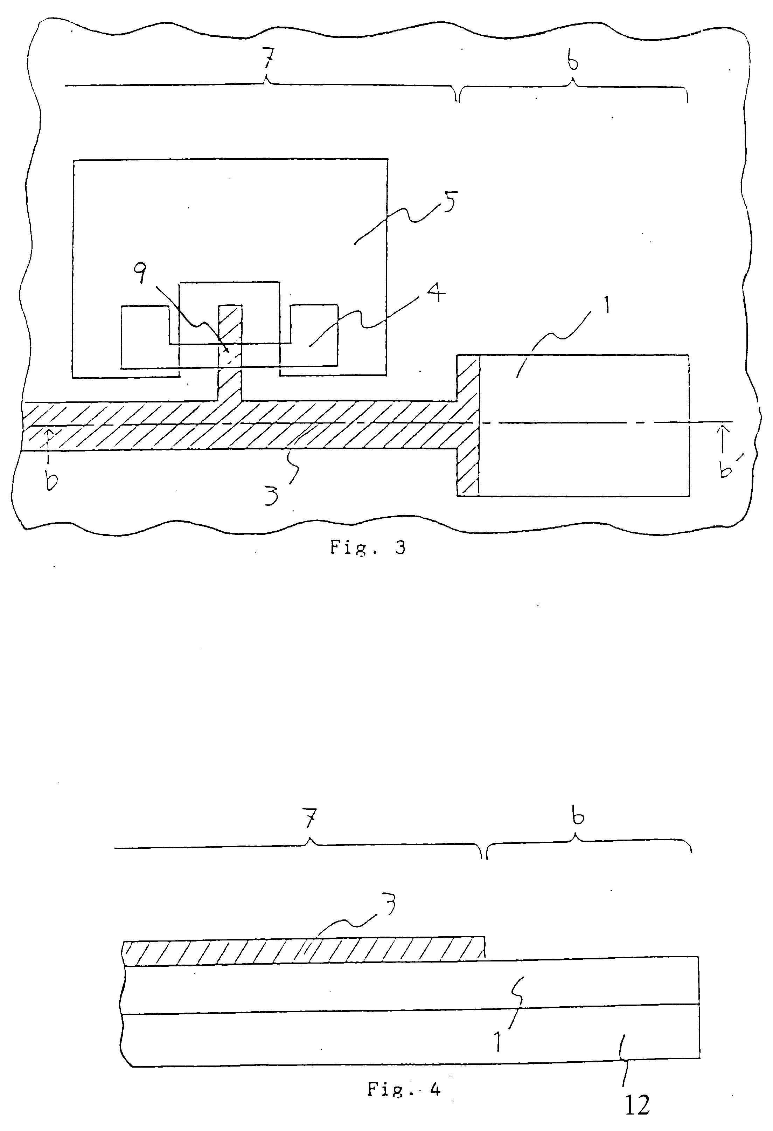

A first conventional liquid crystal display unit using metal-insulator-metal layers (hereinafter referred to as MIM elements) as elements for driving pixels of the display unit is shown in Figures 3 and 4.

The following explantion is based on using tantalum (Ta) / tantalum oxide (TaOx) / chromium (Cr) layers as a typical layer structure for each MIM element. Generally after preparing a tantalum layer, a layer of tantalum oxide is formed all over the tantalum layer by anodic oxidation or thermal oxidation. It should be noted, however, that it is also known to use aluminium (Al), gold (Au), indium tin oxide (ITO), NiCr + Au, ITO + Cr and the like for the metal layers instead of Ta and Cr, and that it is known to use SiOx, SiNx, SiOxNy, TaNx and ZnOx for the insulator layer instead of TaOx.

In Figures 3 and 4, an overlapping part of a tantalum layer 1, a tantalum oxide layer 3 formed on the tantalum layer 1, and a chromium element 4, forms an MIM element 9 for driving a pixel by way of a pixel electrode 5. Signals input from a terminal area 6 provided by the tantalum layer 1 are applied to the pixel electrode 5 through an inter-pixel connection 7, which is provided by the tantalum layer 1 and to the tantalum oxide layer 3, and the MIM element 9. All the layers are formed on a substrate 12.

In the above structure, the number of photo-etching steps necessary in the preparation of an element substrate is: one for the formation of the tantalum layer 1, one for the formation of the chromium element 4, and one for the formation of the pixel electrode 5, that is three steps in total. Actually, as shown in Figure 3, it is necessary to remove the tantalum oxide layer 3 from the terminal area 6 and, therefore, a very simple additional photo-etching step, that does not require precise accuracy, must also be executed.

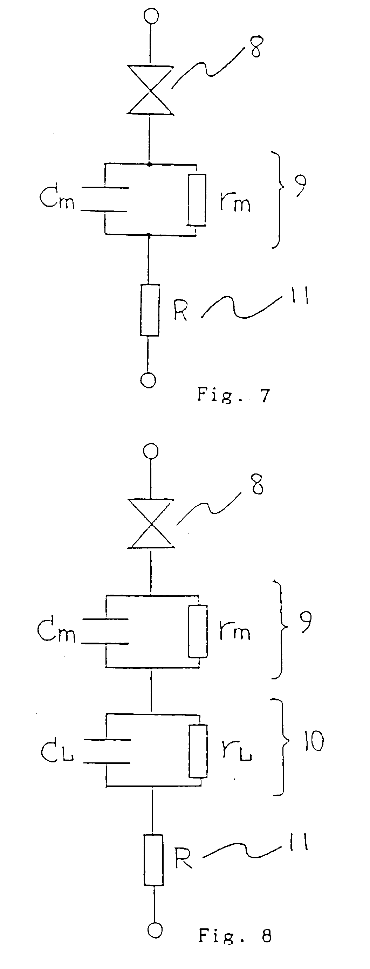

An equivalent circuit diagram is shown in Figure 7. In Figure 7, the distribution resistance of the inter-pixel connection 7 having a value R is represented by a resistance 11 and is provided substantially by the distribution resistance of the tantalum layer 1 because the tantalum oxide layer 3 is an insulator. The MIM element 9 has a structure represented by a capacitor $C_m$ and a resistance $R_m$ connected in parallel. As shown, the resistance 11 and MIM element 9 are connected in series with a liquid crystal layer 8.

Since the resistance of the inter-pixel connection 7 reduces the signal voltage applied from the terminal area 6, a voltage difference arises between signals applied to those pixel electrodes 5 near the terminal area 6 and signals applied to those pixel electrodes 5 remote from the terminal area 6. The display condition of the liquid crystal display unit near the terminal area 6 thus differs from the display condition remote from the terminal area 6, presented as unevenness in contrast. In order to improve the picture quality of the liquid crystal display unit, it is, therefore, desirable to reduce the resistance of the inter-pixel connection 7.

In the case of the structure of Figure 3, the resistance of the inter-pixel connection 7 can be reduced by enlarging the pattern width of a part of the tantalum layer 1 corresponding to the inter-pixel connection 7, or by increasing the thickness of the tantalum layer 1. However, the former method is contrary to a picture quality improvement obtained by densification of the pixels. The latter method has an adverse effect both on pattern accuracy during pattern formation of the tantalum layer 1 and on step coverage of the chromium element 4 at the edge of the tantalum layer 1.

Therefore, it is extremely difficult to reduce distribution resistance of the inter-pixel connection in a satisfactory manner by these two methods.

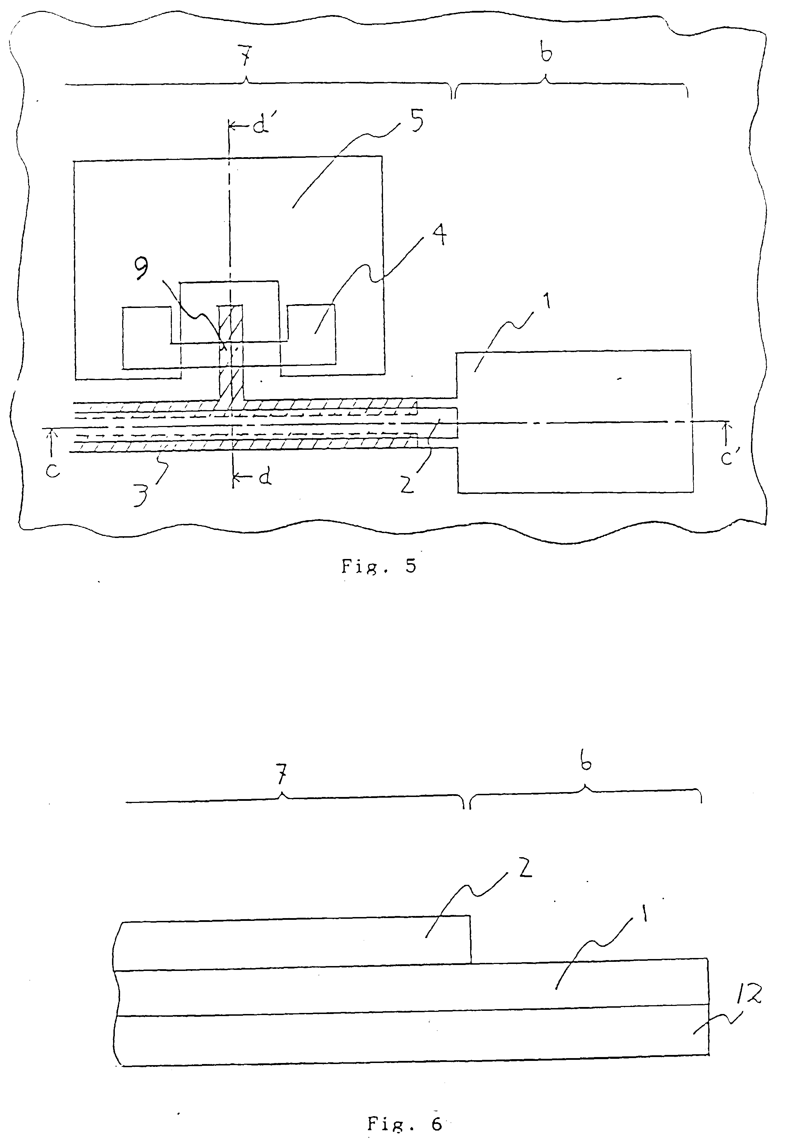

An alternative structure for the inter-pixel connection 7 as shown in Figures 5 and 6 has also been proposed.

Using the same chromium layer forming the chromium element 4, a chromium connection element 2 is arranged on the tantalum layer 1 between portions of the tantalum oxide layer 3 such that the inter-pixel connection 7 has a two layer structure provided by the tantalum layer 1 and the chromium connection element 2.

Although the resistivity of the tantalum layer 1 is approximately 220 micro-ohm-cm, that of the chromium connection element 2 is approximately 30 micro-ohm-cm. Therefore, the above two layer structure is very effective in reducing the resistance of the inter-pixel connection 7.

By increasing the thickness of the chromium layer as the need arises, a sufficiently low resistance can basically be obtained for the inter-pixel connection 7.

However, in this structure, the number of photo-etching steps necessary to prepare an element substrate is: one for the formation of the tantalum layer 1, one for the removal of the tantalum oxide layer 3 at the terminal area 6 and along the inter-pixel connection 7, one for the formation of the chromium element 4 and the chromium connection element 2, and one for the formation of the pixel electrode 5, that is four steps in total.

Consequently, by reducing the distribution resistance of the inter-pixel connection in this way, the cost of producing the liquid crystal display unit is drastically increased and, moreover, the production yield is reduced.

As in the manufacture of semi-conductor products, such as ICs, the cost of producing a liquid crystal display unit depends on the number of photo-etching steps in the process. Therefore, the production costs for the structure in Figure 5 are approximately 4/3 times the costs for the structure in Figure 4.

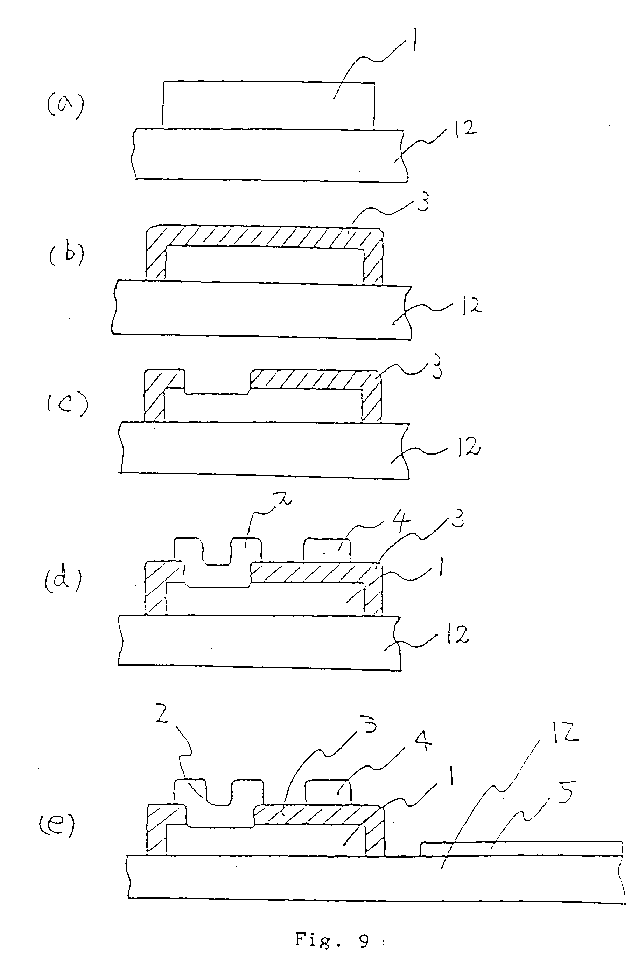

The production process for the structure in Figure is described below with reference to Figures 9 (a) to 9 (e).

First, a thin film of tantalum is formed on the substrate 12, and patterned into a desired configuration to provide the tantalum layer 1 as shown in Figure 9 (a).

Second, the surface of the patterned tantalum layer 1 is oxidized to generate the tantalum oxide layer 3 (see Figure 9 (b)).

The tantalum oxide layer 3 of the inter-pixel connection 7 is removed in a desired portion by boring as shown in Figure 9 (c).

Then, chromium is formed and patterned in a desired configuration to produce the chromium connection element 2 of the inter-pixel connection 7 and the chromium element 4 constituting an upper electrode of the MIM element 9 as shown in Figure 9 (d).

Finally, a transparent conductive film is formed and patterned in a desired configuration to provide the pixel electrode 5 as shown in Figure 9 (e), which corresponds with a section along the line d - d' in Figure 5.

In Figure 9 (c) in the above process, the surface of the tantalum oxide layer 3 in the region where the tantalum layer 1 and the chromium element 4 overlap, that is the region forming the MIM element, is to be exposed to the photo-etching process. Therefore, by comparison with the process for manufacturing the structure shown in Figure 3, defects are increased at the tantalum oxide inter-face of the MIM element, and this results in a reduction in the production yield for the liquid crystal display unit.

As stated above, the conventional structures for liquid crystal display units either have the problem that it is difficult to reduce the distribution resistance of an inter-pixel connection, or the problem that reducing distribution resistance causes a drastic increase in production cost and a reduction in yield.

The present invention seeks to provide an element substrate for a liquid crystal display unit, in which an inter-pixel connection may have a low resistance without increasing cost.

According to the present invention, there is provided a liquid crystal display having a liquid crystal layer between a pair of substrates, pixel electrodes and non-linear elements for driving the pixel electrodes arranged in a matrix on one of the pair of substrates, at least one input terminal portion for receiving driving signals, and corresponding inter-pixel connections coupled to said input terminal portion for enabling the respective non-linear element to receive the driving signals, characterised in that the input terminal portion comprises a multi-layer structure having an insulating layer sandwiched between the or some of the other layers. In another aspect the invention provides a method of manufacturing the liquid crystal display as claimed in claim 7.

The present invention will be described further, by way of example, with reference to the accompanying drawings, in which: -

Figure 1 is a plan view of an element substrate of a liquid crystal display unit according to the present invention:

Figure 2 is a sectional view taken on the line a-a' in Figure 1;

Figure 3 is a plan view of an element substrate of a conventional liquid crystal display unit;

Figure 4 is a sectional view taken on the line b - b' in Figure 3;

Figure 5 is a plan view of an element substrate of a conventional liquid crystal display unit;

Figure 6 is a sectional view taken on the line c - c' in Figure 5;

Figure 7 is an equivalent circuit diagram of a pixel of a conventional liquid crystal display unit;

Figure 8 is an equivalent circuit diagram of a pixel of a liquid crystal display unit of the present invention; and

Figures 9 (a) to 9 (e) are sectional views showing stages in the production process for the element substrate of the conventional liquid crystal display unit of Figures 5 and 6.

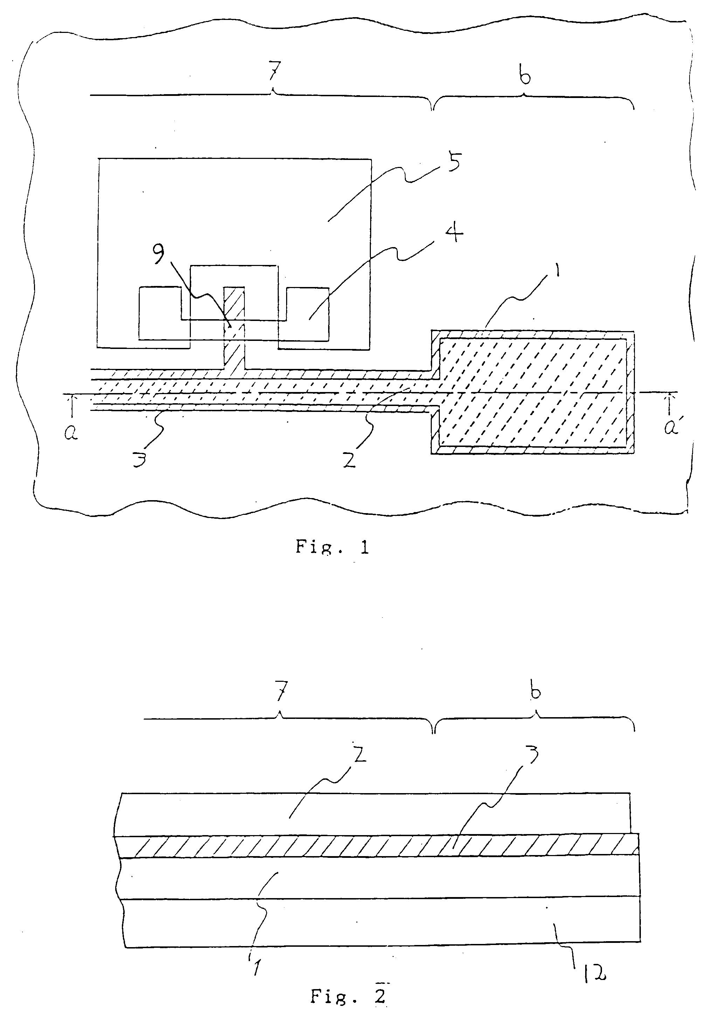

Referring to Figures 1 and 2, an element substrate of a liquid crystal display unit according to the invention is illustrated. Like parts are indicated by the same reference numerals as in Figures 3 to 6.

In this instance, a chromium connection element 2 is formed along an inter-pixel connection 7 and over a terminal area 6 without removing a tantalum oxide layer 3 from the inter-pixel connection 7 or the terminal area 6.

Signals input from the terminal area 6, and thus input to the chromium connection element 2, are applied to a pixel electrode 5 through the tantalum oxide layer 3 of the inter-pixel connection 7 and an MIM element 9.

The tantalum oxide layer 3 is naturally an insulator film. Signals supplied to the chromium connection element 2 are transmitted through this insulator film to a tantalum layer 1 of the inter-pixel connection 7 and thence to the MIM element 9. Now, the insulator film generally has a large insulation resistance. Therefore, the signals cannot be supplied to the MIM element 9 unless they pass through this high resistance portion even when the resistance of the chromium connection element 2 is at a low level.

The inter-pixel connection 7 composed of the chromium connection element 2, the tantalum oxide layer 3 and the tantalum layer 1 has the same structure as the MIM element 9. Moreover, it effectively comprises an MIM portion having a larger area than the MIM element 9, being composed of layers of tantalum, tantalum oxide and chromium. Namely, the signals supplied to the chromium connection element 2 are transmitted through the larger area MIM portion into the MIM element 9.

An equivalent circuit diagram is shown in Figure 8.

In Figure 8, a distribution resistance 11, having a resistance value R, represents the distribution resistance of the inter-pixel connection 7 in Figure 1, and is substantially provided by the distribution resistance of the chromium connection element 2. A connection area MIM portion 10 represents the large area MIM portion, which is composed of the tantalum layer 1, the tantalum oxide layer 3 and the chromium connection element 2 of the inter-pixel connection 7. The qualitative electrical properties of the liquid crystal display unit can be explained on the basis that these parts, namely the MIM portion 10, the MIM element 9, and a liquid crystal layer 8 are connected in series.

In this state, $C_m << C_L$ and $r_m >> r_L$. Since the MIM element 9 and the connection area MIM portion 10 are connected in series:

$$C_o = 1/(1/C_m + 1/C_L)$$

$$= C_m/(1 + C_m/C_L)$$

$$= C_m$$

$$R_o = r_m + r_L$$

$$= r_m (1 + r_L/r_m)$$

$$= r_m$$

where $C_o$ is the composite capacitance of the two MIM portions, and $R_o$ is the composite resistance. As can be seen, from the point of view of the electrical properties, the connection area MIM portion 10 can be ignored as against the MIM element 9.

Therefore, in accordance with the present invention, a liquid crystal display unit having an inter-pixel connection with a low resistance using the chromium connection element 2 is obtained.

In the structure of the present invention, the number of photo-etching steps necessary to prepare an element substrate is: one for the formation of the tantalum layer 1, one for the formation of the chromium element 4 and the chromium connection element 2, and one for the formation of the pixel electrode 5, that is only three steps in total.

In other words, a fewer number of photo-etching steps is necessary than to prepare the conventional element substrate shown in Figure 3 having the high distribution resistance for the inter-pixel connection.

Compared with the number of photo-etching steps necessary to prepare the conventional element substrate shown in Figure 5, having the low distribution resistance as a result of the modified inter-pixel connection 7, which is four steps in total, the production costs for an element substrate can be reduced to 3/4.

Moreover, defects at the tantalum oxide interface of the MIM element can also be reduced drastically, because the surface of the tantalum oxide layer 3 is not exposed to the photo-etching process.

A liquid crystal display unit having element substrates as described above in accordance with the present invention provides an improved picture quality as a result of low distribution resistance of the inter-pixel connections, and, moreover, permits reduced production costs.

Further, the double structure of the inter-pixel connections enables a drastic reduction in defects resulting from dis-connections in the inter-pixel connections.

## Claims

1. A liquid crystal display having a liquid crystal layer between a pair of substrates, pixel electrodes (5) and non-linear elements (9) for driving the pixel electrodes arranged in a matrix on one of the pair of substrates (12), at least one input terminal portion (6) for receiving driving signals, and corresponding inter-pixel connections (7) coupled to said input terminal portion for enabling the respective non-linear element to receive the driving signals, characterised in that the input terminal portion (6) comprising a multi-layer structure having an insulating layer (3) sandwiched between the or some of the other layers.

2. A liquid crystal display as claimed in claim 1, in which the multi-layer structure comprises a low resistance layer (2), the insulating layer (3) and a conductive layer (1) which has a higher resistance than said low resistance layer.

3. A liquid crystal display as claimed in claim 2, in which the low resistance layer (2) covers at least part of the surface area of the insulating layer (3).

4. A liquid crystal display as claimed in claim 2 or 3, in which said multi-layer structure forms a MIM structure.

5. A liquid crystal display as claimed in any one of claims 2, 3 or 4, in which the low resistance layer is formed from chromium.

6. A liquid crystal display as claimed in any one of claims 2 to 5, in which said conductive layer (1) is formed from tantalum and the insulating layer (3) is formed from tantalum oxide.

7. A method of manufacturing a liquid crystal display as claimed in any one of the claims 1 to 6, said method comprising:

providing a pair of substrates;
depositing and etching a first layer of a multi-layer structure and non-linear element on one of the substrates to form one pixel electrode and the first layer of the multi-layer structure providing an input terminal portion and an inter-pixel connection;
depositing and etching the last layer of the multi-layer structure and the non-linear element on said one substrate, and providing a liquid crystal layer between the pair of substrates, characterised by
depositing, but not etching, an intermediate insulating layer of the multi-layer structure thereby reducing the number of etching steps required.

**Patentansprüche**

1. Flüssigkristallanzeige mit einer Flüssigkristallschicht zwischen einem Paar von Substraten, Pixelelektroden (5) und nicht linearen Elementen (9) zum Antreiben der Pixelelektroden, welche in einer Matrix an einem Substrat des Paars von Substraten (12) angeordnet sind, wenigstens einem Eingangsanschlußabschnitt (6) zum Empfangen von Antriebssignalen und entsprechenden Inter-Pixelverbindungen (7), welche mit dem Eingangsanschlußabschnitt gekoppelt sind, um zu ermöglichen, daß die jeweiligen nicht linearen Elemente die Antriebssignale empfangen,
dadurch gekennzeichnet, daß der Eingangsanschlußabschnitt (6) eine Mehrschichtstruktur mit einer Isolationsschicht (3) umfaßt, welche zwischen den oder einigen der anderen Schichten aufgenommen ist.

2. Flüssigkristallanzeige nach Anspruch 1, bei welcher die Mehrschichtstruktur eine Schicht (2) mit geringem Widerstand, die Isolationsschicht (3) und eine Leitungsschicht (1) umfaßt, welche einen höheren Widerstand aufweist als die Schicht mit geringem Widerstand.

3. Flüssigkristallanzeige nach Anspruch 2, bei welcher die Schicht (2) mit geringem Widerstand wenigstens einen Teil des Oberflächenbereichs der Isolationsschicht (3) bedeckt.

4. Flüssigkristallanzeige nach Anspruch 2 oder 3, bei welcher die MehrSchichtstruktur eine MIM-Struktur bildet.

5. Flüssigkristallanzeige nach Anspruch 2, 3 oder 4, bei welcher die Schicht mit geringem Widerstand aus Chrom gebildet ist.

6. Flüssigkristallanzeige nach einem der Ansprüche 2 bis 5, bei welcher die leitende Schicht (1) aus Tantal gebildet ist und die Isolationsschicht (3) aus Tantaloxid gebildet ist.

7. Verfahren zur Herstellung einer Flüssigkristallanzeige nach einem der Ansprüche 1 bis 6, wobei das Verfahren umfaßt:

Vorsehen eines Paars von Substraten,
Ablagern und Ätzen einer ersten Schicht einer Mehrschichtstruktur und eines nicht linearen Elements auf einem der Substrate, um eine Pixelelektrode und die erste Schicht der Mehrschichtstruktur zu bilden, wodurch ein Eingangsanschlußabschnitt und eine Inter-Pixelverbindung vorgesehen werden,
Ablagern und Ätzen der letzten Schicht der Mehrschichtstruktur und des nicht linearen Elements auf dem einen Substrat und Vorsehen einer Flüssigkristallschicht zwischen dem Paar von Substraten,

gekennzeichnet durch das Ablagern, jedoch nicht Ätzen, einer Zwischen-Isolationsschicht der Mehrschichtstruktur, um dadurch die Anzahl an erforderlichen Ätzschritten zu verringern.

**Revendications**

1. Affichage à cristaux liquides comportant une couche de cristaux liquides entre deux substrats, des électrodes de pixels (5) et des éléments non-linéaires (9) pour commander les électrodes de pixels agencés en une matrice sur un des deux substrats (12), au moins une partie de borne d'entrée (6) pour recevoir des signaux de commande et des connexions interpixel (7) correspondantes couplées à ladite partie de borne d'entrée pour permettre à l'élément non-linéaire respectif de recevoir les signaux de commande, caractérisé en ce que la partie de borne d'entrée (6) comprend une structure à couches multiples comportant une couche d'isolation (3) intercalée entre les ou certaines des autres couches.

2. Affichage à cristaux liquides selon la revendication 1, dans lequel la structure à couches multiples comprend une couche de faible résistance (2), la couche d'isolation (3) et une couche conductrice (1) qui a une résistance supérieure à celle de ladite couche de faible résistance.

**3.** Affichage à cristaux liquides selon la revendication 2, dans lequel la couche de faible résistance (2) recouvre au moins une partie de la surface de la couche d'isolation (3).

**4.** Affichage à cristaux liquides selon la revendication 2 ou 3, dans lequel ladite structure à couches multiples forme une structure MIM.

**5.** Affichage à cristaux liquides selon l'une quelconque des revendications 2, 3 ou 4, dans lequel la couche de faible résistance est constituée de chrome.

**6.** Affichage à cristaux liquides selon l'une quelconque des revendications 2 à 5, dans lequel ladite couche conductrice (1) est constituée de tantale et la couche d'isolation (3) est constituée d'oxyde de tantale.

**7.** Procédé de fabrication d'un affichage à cristaux liquides selon l'une quelconque des revendications 1 à 6, ledit procédé comprenant :

la prévision de deux substrats ;
le dépôt et la gravure d'une première couche d'une structure à couches multiples et d'un élément non-linéaire d'un des substrats pour former une électrode de pixel et la première couche de la structure à couches multiples fournissant une partie de borne d'entrée et une connexion interpixel ;
le dépôt et la gravure de la dernière couche de la structure à couches multiples et de l'élément non-linéaire sur ledit premier substrat et la prévision d'une couche de cristaux liquides entre les deux substrats, caractérisé par
le dépôt, mais pas la gravure, d'une couche d'isolation intermédiaire de la structure à couches multiples, ce qui réduit le nombre requis d'étapes de gravure.

Fig. 1

Fig. 2

Fig. 3

Fig. 4

Fig. 5

Fig. 6

Fig. 7

Fig. 8

Fig. 9